# EUROPÄISCHE PATENTSCHRIFT

(11) **EP 0 592 745 B1**
(45) Veröffentlichungstag und Bekanntmachung des Hinweises auf die Patenterteilung: **24.01.1996**
(21) Anmeldenummer: 92810731.7
(22) Anmeldetag: 28.09.1992
(51) Int. Cl.: H05K 3/00, G03F 7/16, B05C 13/02

(54) **Verfahren und Vorrichtung zur beidseitigen Beschichtung von plattenförmigem Stückgut**
Method and apparatus for two-sided coating of plate-like articles
Procédé et dispositif pour le revêtement à deux faces d'articles en forme de plaques

(43) Veröffentlichungstag der Anmeldung: 20.04.1994
(73) Patentinhaber: CIBA-GEIGY AG, CH-4002 Basel (CH)
(72) Erfinder: Kuster, Kaspar, 4057 Basel (CH); Ruegge, Anton, 4123 Allschwil (CH)

(56) Entgegenhaltungen:
- WO-A-87/04584
- WO-A-92/15403
- DE-A- 3 047 578
- US-A- 3 986 476

## Beschreibung

Die Erfindung betrifft ein Verfahren zur beidseitigen Beschichtung von plattenförmigem Stückgut, insbesondere von Leiterplatten, gemäss dem Oberbegriff des Patentanspruchs 1. Die Erfindung betrifft auch eine Vorrichtung zur beidseitigen Beschichtung von plattenförmigem Stückgut, insbesondere von Leiterplatten, gemäss dem Oberbegriff des Patentanspruchs 6.

Leiterplatten werden nachdem sie mit Leiterbahnen versehen sind mit einer Schutzschicht beschichtet. Bei dieser Schutzschicht handelt es sich um einen vorzugsweise UV-härtbaren belichtbaren Kunststoff, Lack oder dergleichen. Nach dem Trocknen der Schutzschicht wird diese in geeigneter Form belichtet und an den belichteten Stellen herausentwickelt. An diesen Stellen liegen dann die Leiterbahnen frei und können elektrisch kontaktiert werden. Bei beidseitig mit Leiterbahnen versehenen Leiterplatten wird auch die zweite Oberfläche der Platten beschichtet und analog zur ersten Oberfläche behandelt. Die Beschichtung der Leiterplatten erfolgt in einer Beschichtungsanlage, die eine Reihe von Bearbeitungsstationen umfasst, durch welche von den zu beschichtenden Leiterplatten der Reihe nach durchlaufen werden.

Die zuvor gereinigten Leiterplatten werden zum Eingang einer Beschichtungsstation transportiert, in der die Leiterplatten auf einer Seite mit der Schutzschicht versehen werden. Die Beschichtungsstation umfasst einen Giesstisch mit einem frei fallenden Giessvorhang, unter dem die Leiterplatten mit der zu beschichtenden Oberfläche nach oben hindurchtransportiert werden. Falls gewünscht bzw. erforderlich, ist vor der Beschichtungsstation eine Vorwärmstation angeordnet. Dort werden die zuvor gereinigten Leiterplatten vor der Beschichtung in einem Heissluftstrom vorgewärmt. Von der Vorwärmstation, die üblicherweise als Umlaufofen ausgebildet ist, werden die Leiterplatten an die Beschichtungsstation übergeben. Nach der Beschichtung der ersten Seite werden die Leiterplatten zu einer im Anschluss an die Beschichtungsstation angeordneten Ablüft- und Trockenstation transportiert. In der Ablüft- und Trockenstation wird Heissluft über die beschichtete Oberfläche der Leiterplatten geführt. Auf diese Weise wird in der Beschichtung enthaltenes Lösungsmittel evaporiert (abgelüftet) und abgesaugt, und wird die beschichtete Oberfläche zmindest teilweise getrocknet. Bei den bekannten Beschichtungsanlagen zur beidseitigen Beschichtung von Leiterplatten werden die Leiterplatten in der Ablüft- und Trockenstation auch gewendet, sodass die beschichtete Oberfläche der Leiterplatte ausgangsseitig der Station nach unten weist, während die noch unbeschichtete Seite der Leiterplatte nach oben weist und beschichtet werden kann. Dazu werden die Leiterplatten erneut unter einem Giessvorhang einer Beschichtungsstation hindurchtransportiert, beschichtet und schliesslich in einer Abluft- und Trockenstation abgelüftet und getrocknet. Danach werden die nunmehr beidseitig beschichteten und getrockneten Leiterplatten zu weiteren Bearbeitungsstationen transportiert.

Eine für die beidseitige Beschichtung von Leiterplatten ausgebildete Beschichtungsanlage ist beispielsweise in der US-A-4.926,789 beschrieben. Bei dieser bekannten Beschichtungsanlage sind im Anschluss an die erste Beschichtungsstation und an die erste Ablüft- und Trockenstation eine zweite Beschichtungsstation und eine zweite Ablüft- und Trockenstation angeordnet. Die in der ersten Ablüft- und Trockenstation gewendeten Leiterplatten werden mit der noch unbeschichteten Oberfläche nach oben unter dem frei fallenden Giessvorhang der zweiten Beschichtungsstation hindurch transportiert. Danach werden sie in der zweiten Ablüft- und Trockenstation durch einen oder zwei hintereinander angeordnete umlaufende Ablüfttrockner transportiert. Dabei wird wiederum Heissluft über die beschichteten Oberflächen geführt, um in der Beschichtung enthaltenes Lösungsmittel zu evaporieren (abzulüften), wird das Lösungsmittel abgesaugt, und werden die Leiterplatten getrocknet. Alle Bearbeitungsstationen dieser Beschichtungsanlage zur beidseitigen Beschichtung von Leiterplatten sind in einer Linie hintereinander angeordnet. Obwohl die Vortrockenstation und die Ablüft- und Trockenstationen im allgemeinen als vertikale Umlauftrockner ausgebildet sind, erreicht die Anlage immer noch eine beachtliche Baulänge. Als Aufstellorte kommen daher nur relativ lange Industriehallen in Frage.

In der US-A-5,113,785 und in der US-A-5,113,701 sind Beschichtungsanlagen beschrieben, welche es erlauben Leiterplatten wahlweise einseitig oder auch zweiseitig zu beschichten. Die beschriebenen Beschichtungsanlagen umfassen nur eine einzige Beschichtungsstation und eine einzige Ablüft- und Trockenstation, die vorzugsweise als vertikaler Umlauftrockner ausgebildet ist. Sollen die Leiterplatten beidseitig beschichtet werden, dann werden sie nach dem Wenden erneut unter dem Giessvorhang der ersten Beschichtungsstation hindurch transportiert und anschliessend in der einzigen Ablüft- und Trockenstation abgelüftet und getrocknet.

Bei der in der US-A-5,113,785 beschriebenen Anlage sind die Beschichtungsstation und die Ablüft- und Trockenstation in Längsrichtung der Anlage nebeneinander angeordnet. Vor und hinter der Beschichtungsstation bzw. der Ablüft- und Trockenstation sind Querförderer angeordnet, die die Leiterplatten aus der Transportzeile mit der Beschichtungsstation in die daneben angeordnete Transportzeile mit der Ablüft- und Trockenstation umsetzen. Als Querförderer werden beispielsweise quer zur Längsrichtung der Beschichtungsanlage angeordnete Hubbänder eingesetzt. In einer zweiten Variante sind in der US-A-5,113,785 als Querförderer Hub- und Schwenkrechen vorgeschlagen, welche die Leiterplatten aus der Transportzeile mit der Beschichtungsstation in die daneben angeordnete Transportzeile mit der Ablüft- und Trockenstation umsetzen und umgekehrt. Durch die Anordnung der Beschichtungsstation und der Ablüft- und Trockenstation nebeneinander anstatt hintereinander wird die Gesamtlänge der Beschichtungsanlage deutlich reduziert. Allerdings sind für das Umsetzen der Leiterplatten aus der einen Transportzeile in die zweite daneben angeordnete zusätzliche Querförderer erforderlich. Diese sind konstruktiv relativ aufwendig und erfordern eine exakte Abstimmung ihrer Funktion auf den Arbeitstakt der Ablüft- und Trockenstation einerseits und auf den der Beschichtungstation andererseits.

Die in der US-A-5,113,701 beschriebene Beschichtungsanlage ist einzeilig aufgebaut und kommt ohne zusätzliche Querförderer aus. Bei dieser integrierten Anlage ist die Ablüft-und Trockenstation im wesentlichen oberhalb der Beschichtungsstation angeordnet. Die einseitig oder beidseitig beschichteten Leiterplatten werden abgelüftet und getrocknet während sie in speziell ausgebildeten Haltevorrichtungen oberhalb der Beschichtungsstation wieder an den den Eingang der Beschichtungsstation oder zum Ausgang der Beschichtungsanlage transportiert werden. Abgesehen von dem Erfordernis von speziellen Halterungen für die Leiterplatten weist diese Beschichtungsanlage eine relativ grosse Bauhöhe auf, da die Ablüft- und Trockenstation im wesentlichen oberhalb der Beschichtungsstation angeordnet ist.

Die Aufgabe der vorliegenden Erfindung besteht daher darin den Nachteilen dieser Beschichtungsanlagen des Standes der Technik abzuhelfen. Insbesondere sollen durch die Erfindung ein Verfahren und eine Vorrichtung zur beidseitigen Beschichtung von plattenförmigem Stückgut, insbesondere von Leiterplatten geschaffen werden, welche ohne zusätzliche Querförderer auskommen. Dabei soll die Vorrichtung eine möglichst kurze Baulänge aufweisen. Auch soll ihre Bauhöhe gering sein und im wesentlichen nur durch die Bauhöhe der vertikalen Durchlauftrockner bestimmt sein.

Die Lösung dieser und noch weiterer damit zusammenhängender Aufgaben besteht in einem Verfahren zur beidseitigen Beschichtung von plattenförmigem Stückgut, insbesondere von Leiterplatten, welches die im kennzeichnenden Abschnitt des Patentanspruchs 1 angeführten Verfahrensschritte aufweist, und in einer Vorrichtung zur beidseitigen Beschichtung von plattenförmigem Stückgut, insbesondere von Leiterplatten, gemäss Kennzeichen des Patentanspruchs 6. Durch die Erfindung wird ein Verfahren zur beidseitigen Beschichtung von plattenförmigem Stückgut, insbesondere von Leiterplatten, vorgeschlagen, bei dem das Stückgut durch mehrere aufeinanderfolgende Bearbeitungsstationen einer Beschichtungsanlage transportiert wird und in einer ersten Beschichtungsstation zunächst eine erste Seite des Stückguts mit vorzugsweise UV-härtbarem Kunststoff oder Lack nass beschichtet wird, nach dem Beschichten der ersten Seite das Stückgut in einer ersten Ablüft- und Trockenstation jeweils abgelüftet und getrocknet wird, das Stückgut gewendet und in einer zweiten Beschichtungsstation die zweite Seite mit vorzugsweise UV-härtbarem Kunststoff oder Lack nass beschichtet wird und das derart beidseitig beschichtete Stückgut in einer zweiten Ablüft- und Trockenstation abgelüftet und getrocknet wird und schliesslich zur weiteren Bearbeitung aus der Beschichtungsanlage an weitere Bearbeitungsvorrichtungen übergeben wird. Erfindungsgemäss ist das Verfahren dadurch gekennzeichnet, dass das Stückgut in entgegengesetzte Richtungen durch die beiden Beschichtungsstationen transportiert wird, welche in zwei parallel zueinander verlaufenden Gerätezeilen nebeneinander angeordnet sind, und dass das Stückgut in der ersten Ablüft- und Trockenstation gewendet und aus der ersten Gerätezeile in die zweite umgesetzt wird. Auf diese Weise ist die Gesamtlänge der Beschichtungsanlage deutlich reduziert. Es sind auch keine zusätzlichen Umsetzmittel bzw. Querförderer für die Leiterplatten erforderlich. Die Leiterplatten werden vorzugsweise in der quer zu den Transportrichtungen angeordneten ersten Ablüft- und Beschichtungsstation gewendet und von der ersten Gerätezeile mit der ersten Beschichtungsstation in die zweite Gerätezeile mit der zweiten Beschichtungsstation umgesetzt.

Um die Haftung der Beschichtung auf den Leiterplatten zu erhöhen und ihre Trocknung zu forcieren, ist es vorteilhaft, die Leiterplatten eingangs der Beschichtungsanlage vor dem Transport durch die erste Beschichtungsstation in einer Vorwärmstation vorzuwärmen. Dabei ist es besonders vorteilhaft, wenn die Vorwärmstation und die zweite Ablüft- und Trockenstation durch einen einzigen Ablüfttrockner gebildet werden. Auf diese Weise kann ein Trockner eingespart werden. Die Leiterplatten werden nach der beidseitigen Beschichtung während des abschliessenden Ablüft- und Trockenvorgangs im Ablüftrockner aus der zweiten Gerätezeile wieder in die erste Gerätezeile umgesetzt.

Vorzugsweise werden die Leiterplatten eingangs der ersten Gerätezeile der Beschichtungsstation in Halterungen eingegeben, die an einem abwärtsbewegten Trum eines Umlaufförderers, vorzugsweise eines Kettenförderers, der im Ablüfttrockner angeordnet ist, befestigt sind, wobei die Eingabeebene oberhalb der Transportebne in der ersten Gerätezeile verläuft, und dass die Leiterplatten nach dem abschliessenden Ablüften und Trocknen aus den abwärtsbewegten Halterungen des Ablüfttrockners ausgefahren werden, wobei die Ausgabeebene oberhalb der Eingabeebene verläuft.

Ein besonders schonender Transport der Leiterplatten wird erreicht, wenn sie während ihres Transportes durch die einzelnen Bearbeitungsstationen der Beschichtungsanlage und während ihrer Übergabe an die verschiedenen Transportmittel der einenzelnen Bearbeitungsstationen im wesentlichen ständig an den Längsrändern geführt oder gestützt werden.

Die erfindungsgemäße Vorrichtung zur beidseitigen Beschichtung von plattenförmigem Stückgut, insbesondere von Leiterplatten, einer Reihe von Bearbeitungsstationen, die nacheinander von dem Stückgut durchlaufen werden, umfasst in der Reihenfolge ihrer Anordnung eine erste Beschichtungsstation, eine Ablüft- und Trockenstation, eine zweite Beschichtungsstation und eine zweite Ablüft- und Trockenstation. Die erste und die zweite Beschichtungsstation sind in zwei parallel zueinander verlaufenden Gerätezeilen mit entgegengesetzten Transportrichtungen nebeneinander angeordnet. Die erste Ablüft- und Trockenstation ist derart zwischen der ersten und der zweiten Beschichtungsstation angeordnet, dass ihre Längserstreckung quer zu den Transportrichtungen des Stückguts in den Beschichtungsstationen verläuft. Halterungen für das Stückgut, die am aufwärts führenden Trum eines in der ersten Ablüft- und Trockenstation vorgesehenen Umlaufförderers, vorzugsweise eines Kettenförderers, der das Stückgut wendet, bestigt sind, erstrecken sich quer und benachbart zur ersten Gerätezeile, während Halterungen, die am abwärts führenden Trum des Umlaufförderers befestigt sind, quer und benachbart zur zweiten Gerätezeile verlaufen.

Vorzugsweise ist eingangs der Beschichtungsanlage vor der ersten Beschichtungsstation eine Vorwärmstation für die Leiterplatten angeordnet. Besonders vorteilhaft ist es, wenn die Vorwärmstation und die zweite Ablüft- und Trockenstation durch einen Umlauftrockner gebildet sind, dessen Längserstreckung parallel zur Längserstreckung der ersten Ablüft- und Trockenstation verläuft. Der Umlauftrockner weist eine Eingabe- und eine Ausgabestation für die Leiterplatten auf, die etwa mit der ersten Gerätezeile fluchtend im Bereich des abwärtsführenden Trums des innerhalb des Umlauftrockners angeordneten Umlaufförderers, vorzugsweise eines Kettenförderers, derart angeordnet sind, dass die Eingabeebene oberhalb der Transportebene der Leiterplatten in der ersten Beschichtungsstation und unterhalb der Ausgabeebene verläuft.

Die Breite der Halterungen für die Leiterplatten in den Ablüft- und Trockenstationen ist vorzugsweise auf die Breite der Leiterplatten einstellbar. In einer besonders bevorzugten Ausführungsvariante umfasst jede Halterung zwei parallel angeordnete Halteschienen für die Längsränder der Leiterplatten. Eine der Halteschienen ist fest mit dem Umlaufförderer verbunden, während die andere Halteschiene mit Hilfe von Verstellmitteln entlang einer Führungsstange, die sich senkrecht zu der festen Halteschiene erstreckt und fest mit ihr verbunden ist, vorzugsweise gebremst, derart parallelverschiebbar ist, dass der Abstand zwischen den Halteschienen auf die Breite der einzufahrenden Leiterplatte einstellbar ist.

Für den schonenden Transport der einseitig bzw. beidseitig beschichteten Leiterplatten ist es besonders vorteilhaft, dass die Längsränder der Leiterplatten in jeder Beschichtungsstation von seitlichen Führungsmitteln gehalten werden, die mit vorzugsweise elektro-pneumatischen Verstellmitteln jeweils automatisch auf die Breite einer zu beschichtenden Leiterplatte einstellbar sind, und dass die Verstellmittel für die Breitenverstellung der Tragelemente der Abluft- und Trockenstation und die Verstellmittel für die Breitenverstellung der seitlichen Führungsmittel für die Längsränder der Leiterplatten in der Beschichtungsstation miteinander gekoppelt sind.

Die Gesamtanlage kann besonders platzsparend aufgebaut werden, wenn die erste Ablüft- und Trockenstation ein Luftaufbereitungsmodul aufweist, welches in einem Gehäuse angeordnet ist, das eingabe- bzw. ausgabeseitig an den ersten Ablüfttrockner anschliesst und sich über den freien Raum oberhalb der Beschichtungsstationen erstreckt. Dabei ist es besonders vorteilhaft, wenn die erste Ablüft- und Trockenstation und die zweite Ablüft- und Trockenstation und gegebenenfalls die Vortrockenstation ein gemeinsames Luftaufbereitungsmodul aufweisen. Auf diese Weise wird der Platzbedarf weiter reduziert. Die Anzahl der erforderlichen Versorgungs- bzw. Entsorgungsanschlüsse wird ebenfalls reduziert. Im Idealfall ist bloss noch ein einziger Abluftanschluss erforderlich, sowie ein weiterer Anschluss für die Energieversorgung.

In einer weiteren Ausführungsvariante der erfindungsgemässen Beschichtungsanlage sind die Beschichtungsstationen durch bauliche Massnahmen, vorzugsweise durch Plexiglaswände, die sich zwischen den Ablüft- und Trockenstationen erstrecken und gegebenenfalls von der Unterkante des Gehäuses für das Luftaufbereitungsmodul bis zum Boden reichen, im wesentlichen von der Umgebungluft abgeschottet sind.

Besonders zweckmässig ist es auch, wenn die beiden nebeneinander angeordneten Beschichtungsstationen einen gemeinsamen Giesstisch mit unabhängig voneinander antreibbaren seitlichen Führungsmitteln für die Längsränder der Leiterplatten in der ersten Beschichtungsstation und in der zweiten Beschichtungsstation umfassen, und dass der Giesstisch zwei frei fallende Giessvorhänge aus vorzugsweise UV-härtbarem Kunststoff, Lack oder dergleichen aufweist, die aus einem oberhalb der Transportebene der Leiterplatten angeordneten Reservoir gespeist werden. Auf diese Weise ist nur mehr eine einzige Pumpe samt Viskositäts- und Temperaturregelung für den lichtempfindlichen Kunststoff, Lack oder dgl. erforderlich. Weitere besonders bevorzugte Verfahrensvarianten bzw. Ausführungsbeispiele der erfindungsgemässen Vorrichtung ergeben sich aus der Beschreibung in Verbindung mit den schematischen Zeichnungen. Es zeigen:
- Fig. 1: ein erstes Ausführungsbeispiel der erfindungsgemässen Beschichtungsanlage in teilweisem Längsschnitt,
- Fig. 2: eine teilweise gescnittene Aufsicht der Beschichtungsanlage gemäss Fig. 1, und
- Fig. 3: eine teilweise geschnittene Aufsicht eines zweiten Ausführungsbeispiels der erfindungsgemässen Beschichtungsanlage.

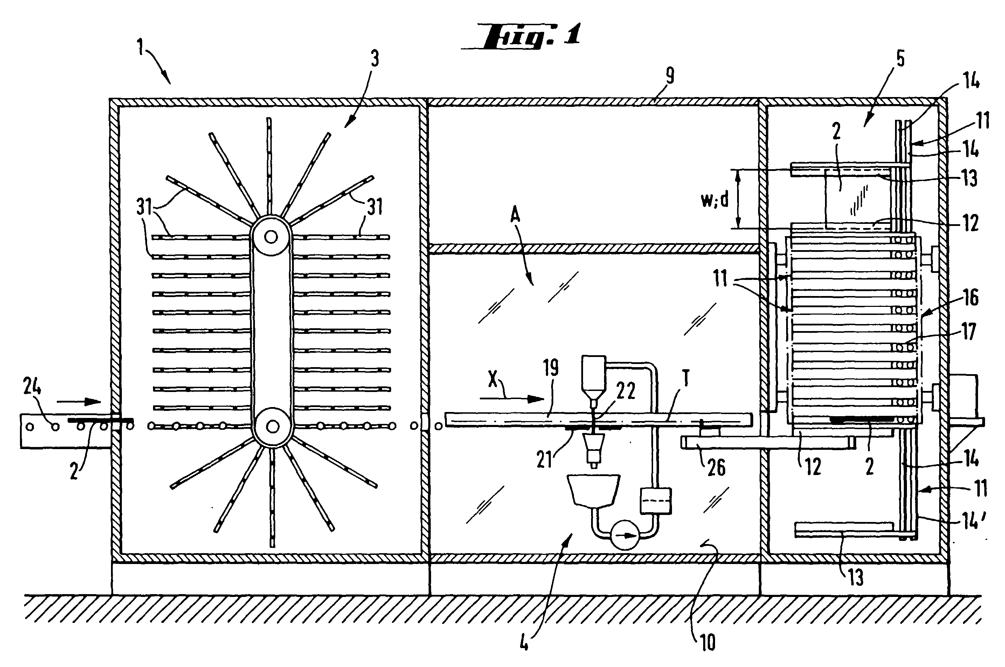

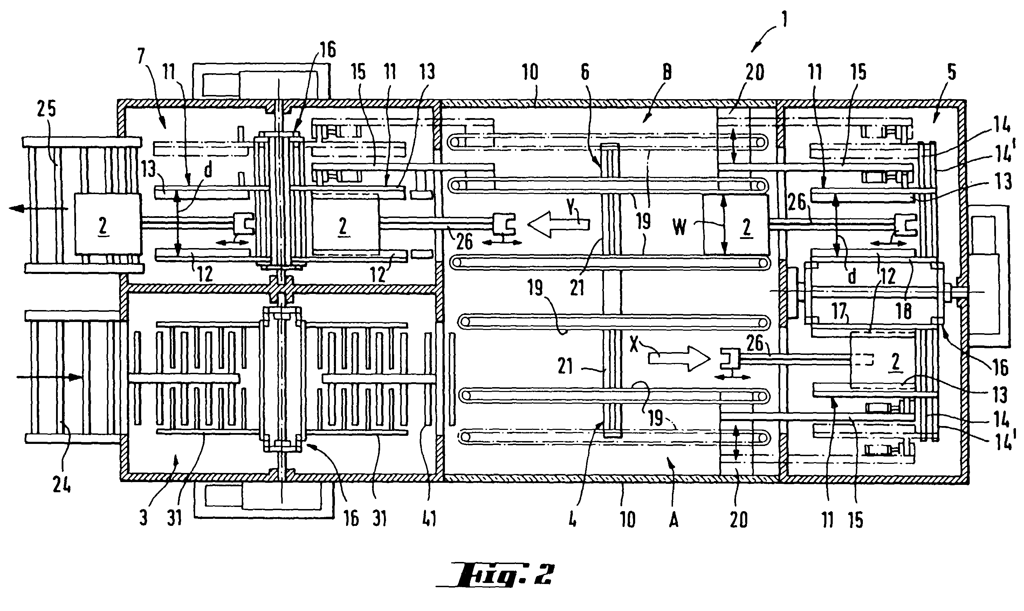

In den Fig. 1 und 2 ist ein erstes Ausführungsbeispiel der erfindungsgemässen Beschichtungsanlage in teilweisem Längsschnitt bzw. in teilweiser Aufsicht dargestellt. Die Beschichtungsanlage ist gesamthaft mit dem Bezugszeichen 1 versehen. Die Beschichtungsanlage weist eine Reihe von Bearbeitungsstationen für Leiterplatten 2 auf, die teils hintereinander und teils in zwei Gerätezeilen A und B nebeneinander angeordnet sind. Insbesondere umfasst die Beschichtungsstation in der ersten Gerätezeile A eine erste Beschichtungsstation 4 zur Beschichtung der Leiterplatten mit vorzugsweise UV-härtbarem Kunststoff, Lack oder dergleichen.
Die erste Beschichtungsstation 4 umfasst einen Giesstisch 21 mit einem Giesskopf. Der Giesskopf ist dabei derart ausgebildet, dass der vorzugsweise UV-härtbare Kunststoff, Lack oder dergleichen, der zum Giesskopf gepumpt wird, einen frei fallenden Giessvorhang 22 bildet, unter dem die zu beschichtenden Oberflächen der Leiterplatten 2 hindurchtransportiert werden. Die seitliche Ausdehnung des Giessvorhangs 22, quer zur Transportrichtung X der Leiterplatten 2, wird dabei durch Giessmesser begrenzt. Ein derartiger Giesskopf ist beispielsweise in der US-A-4,559,896 beschrieben. Durch die Giessmesser ist sichergestellt, dass ein schmaler Rand entlang der Längsseiten der Leiterplatten 2 frei von der Beschichtung bleibt. Vorzugsweise werden die Leiterplatten 2 in der Beschichtungsstation 4 an den Längsrändern geführt. Dazu sind in der Beschichtungsstation 4 seitliche Führungsmittel 19 vorgesehen. Vorzugsweise sind diese durch zwei seitlich angeordnete Transportbänder gebildet, welche jeweils in Transportrichtung X der Leiterplatten 2 um einen zugehörigen Richtholm herumlaufen. Einer der Richtholme, vorzugsweise der innere, ist ortsfest angeordnet, der zweite Richtholm ist auf die Breite der Leiterplatten automatisch, vorzugsweise mit elektro-pneumatischen Verstellmitteln 20 einstellbar. Auf diese Weise werden die Leiterplatten 2 ausgerichtet, sodass ihre Längskanten etwa parallel zur Transportrichtung X verlaufen. Die Transportbänder greifen die Längskanten der Leiterplatten 2 und transportieren sie zur Beschichtung unter dem frei fallenden Giessvorhang 22 hindurch. Dabei sorgt die seitlich den Giessvorhang begrenzenden Giessmesser dafür, dass die Transportbänder nicht verschmutzt werden. Eine derartige Beschichtungsstation mit allen ihren Einzelheiten ist beispielsweise in der europäischen Patentanmeldung Nr.91810879.6 beschrieben.

Seitlich neben der ersten Beschichtungsstation 4 ist in der zweiten Gerätezeile B der Beschichtungsanlage 1 eine zweite Beschichtungsstation 6 angeordnet. Der Aufbau der zweiten Beschichtungsstation 6 entspricht im wesentlichen dem der ersten Station. Die Transportrichtung Y für die zu beschichtenden Leiterplatten verläuft etwa parallel aber entgegengesetzt zu der Transportrichtung A in der ersten Beschichtungsstation.

Zwischen der ersten Beschichtungsstation 4 und der zweiten Beschichtungsstation 6 ist eine erste Ablüft- und Trockenstation angeordnet. Die Anordnung der ersten Ablüft- und Trockenstation 5 ist dabei derart, dass ihre Längserstreckung etwa quer zu den Transportrichtungen X bzw. Y der Leiterplatten 2 in den Beschichtungsstationen 4 bzw. 6 verläuft. Die erste Ablüft- und Trockenstation 5 umfasst einen Umlaufförderer 16, der vorzugsweise als Kettenförderer ausgebildet ist. Der Umlaufförderer ist mit Halterungen 11 ausgestattet, die jeweils zwei Halteschienen 12, 13 für die Längsränder der Leiterplatten 2 aufweisen. Eine feste Halteschiene 12 ist fest mit dem Umlaufförderer, beispielsweise mit endlos umlaufenden Ketten eines Kettenförderers, verbunden. Die zweite Halteschiene 13 ist entlang einer Führungsstange 14, die sich von der festen Halteschiene weg nach aussen erstreckt, parallel zur festen Halteschiene 12 verschiebbar. Eine zweite Führungsstange 14' dient zur Abstützung der verschiebbaren Halteschiene. Auf diese Weise ist der Abstand d der beiden Halteschienen 12, 13 jeder Halterung 11 auf die Breite w der Leiterplatten 2 einstellbar. Vorzugsweise weist die verschiebbare Halteschiene 13 eine Bremseinrichtung, beispielsweise einen federbelasteten Bremsschuh auf, der gegen die Führungsstange 14 gedrückt ist und einerseits die Verstellung bremst und andererseits die verstellbare Halteschiene gegen eine unbeabsichtigete selbsttätige Verstellung sichert. Die Verstellung der verschiebbaren Halteschiene 13 erfolgt am aufwärts führenden Trum 17 des Umlaufförderers 16 vorzugsweise mit elektro-pneumatischen Verstellmitteln 15. Besonders vorteilhaft ist es, die Verstellmittel 15 für die verschiebbare Halteschiene 13 mit den Verstellmitteln 20 für die seitlichen Führungsmittel 19 für die Leiterplatten 2 in der ersten Beschichtungsstation 4 zu koppeln. Die Halteschienen 12, 13 weisen vorzugsweise einen V- oder U-förmigen Querschnitt auf oder sind mit einer Längsnut versehen, um die Längsränder der Leiterplatten 2 aufzunehmen. Das Einschieben bzw. das Ausfahren der Leiterplatten 2 in die bzw. aus den Halterungen 11 erfolgt mit Hilfe von unterhalb der Transportebene T der Leiterplatten 2 in den Beschichtungsstationen 4 bzw. 6 angeordneten Einzugs- bzw. Ausgabemitteln, die vorzugsweise elektro-pneumatisch betätigbar sind. Die erste Ablüft-und Trockenstation 5 ist derart angeordnet, dass die Halterungen 11 für die Leiterplatten 2, die am aufwärts führenden Trum 17 des Umlaufförderers 16, vorzugsweise eines Kettenförderers, befestigt sind, sich quer zur ersten Gerätezeile A erstrecken, während die Halterungen 11, die am abwärts führenden Trum 18 des Umlaufförderers 16 befestigt sind, sich quer zur zweiten Gerätezeile B erstrecken.

Im Anschluss an die zweite Beschichtungstation 6 ist eine zweite Ablüft- und Trockenstation 7 angeordnet, an die die Leiterplatten 2 nach der Beschichtung der zweiten Seite übergeben werden. Die zweite Ablüft- und Trockenstation 7 ist in dem in den Fig. 1 und 2 dargestellten Ausführungsbeispiel längs in der zweiten Gerätezeile B angeordnet, das heisst, ihre Längserstreckung verläuft parrallel zu und liegt in der zweiten Gerätezeile B. Vorzugsweise weist auch die zweite Ablüft- und Trockenstation 7 Halterungen 11 für die Leiterplatten 2 auf, welche zwei Halteschienen, eine feststehende 12 und eine verschiebbare 13, umfasst, deren Abstand d voneinander auf die Breite w der Leiterplatten 2 einstellbar ist. Wiederum sind vorzugsweise elektro-pneumatisch betätigbare Verstellmittel 15 für die verschiebbare Halteschiene 13 vorgesehen. Dabei sind die Verstellmittel 15 für die verschiebbare Halteschiene 13 vorzugsweise mit den Verstellmitteln 20 für die seitlichen Führungsmittel 19 für die Längsränder der Leiterplatten 2 in der zweiten Beschichtungsstation 6 gekoppelt. Diese Kopplung kann regelungstechnischer Natur sein, es kann sich aber auch um eine einfache mechanische Kopplung handeln. Beispielsweise weisen die Verstellmittel 20 für die seitlichen Führungsmittel 19 in der zweiten Beschichtungsstation 6 eine Stellarm auf, der zusammen mit dem verstellbaren Führungsmittel 19 verschiebbar ist und mit den Verstellmitteln 15 für die verschiebbare Halteschiene 13 in Eingriff brinbar ist. Das Einschieben bzw. das Ausfahren der Leiterplatten 2 in die bzw. aus den Halterungen 11 erfolgt mit Hilfe von unterhalb der Transportebene T der Leiterplatten 2 in den Beschichtungsstationen 4 bzw. 6 angeordneten Einzugs- bzw. Ausgabemitteln, die vorzugsweise elektro-pneumatisch betätigbar sind. Die beidseitig beschichteten und getrockneten Leiterplatten werden ausgangs der zweiten Ablüft- und Trockenstation 7 beispielsweise auf eine Ausgaberollenbahn 25 abgelegt, von der sie zu weiteren Bearbeitungsvorrichtungen transportiert werden können.

Die in den Fig. 1 und 2 beispielsweise dargestellte erfindungsgemässe Beschichtungsanlage 1 zur beidseitigen Beschichtung von plattenförmigem Stückgut, insbesondere von Leiterplatten 2, weist eingangs der Beschichtungsanlage 1, vor der ersten Beschichtungsstation 4 eine Vorwärmstation 3 auf. Diese Vorwärmstation weist gleichfalls Halterungen 31 für die Leiterplatten 2 auf, die von einer Eingaberollenbahn 24 in dieselben eingefahren werden. Die Vorwärmstation 3 umfasst ähnlich den Ablüft- und trockenstationen 5 und 7 einen Umlaufförderer 16. Die Vorwärmstation weist eine im wesentlichen vertikal orientierte Bauweise auf. Die etwa horizontal abstehenden Halterungen 11 werden vertikal in die Höhe transportiert, am oberen Umlenkpunkt umgelegt, sodass die in den Halterungen 11 befindlichen Platten 2 gewendet werden, und etwa horizontal von den Ketten oder Seilen oder ähnlichen Förderelementen des Umlaufförderers 16 wegstehend wieder vertikal nach unten transportiert. Ausgangs der Vorwärmstation 3 werden die Leiterplatten 2 auf eine Übergaberollenbahn 41, abgelegt, welche den Eingang zur ersten Beschichtungsstation darstellt. Mit Hilfe der Seitlichen Führungsmittel 19 werden die Leiterplatten sodann unter dem Giessvorhang 22 hindurchtransportiert.

Zur beidseitigen Beschichtung werden die Leiterplatten 2 durch die einzelnen aufeinanderfolgenden Bearbeitungsstationen der Beschichtungsanlage 1 transportiert. Nach dem Vorwärmen der Leiterplatten 2 in der Vorwärmstation 3 wird in der ersten Beschichtungsstation 3 zunächst die erste Seite der Leiterplatten 2 mit vorzugsweise UV-härtbarem Kunststoff, Lack oder dergleichen nass beschichtet. Nach dem Beschichten der ersten Seite werden die Leiterplatten in der ersten Ablüft- und Trockenstation 5 jeweils abgelüftet und getrocknet. Dabei werden die Leiterplatten 2 gewendet und in der zweiten Beschichtungsstation ihre zweite Seite mit vorzugsweise UV-härtbarem Kunststoff, Lack oder dergleichen nass beschichtet. Die derart beidseitig beschichteten Leiterplatten 2 werden in der zweiten Ablüft- und Trockenstation 7 abgelüftet und getrocknet und schliesslich zur weiteren Bearbeitung aus der Beschichtungsanlage 1 an weitere Bearbeitungsstationen übergeben. In den beiden nebeneinander angeordneten Beschichtungsstationen 4 bzw. 6 werden die Leiterplatten in zueinander parallele aber entgegengesetzte Richtungen X, Y transportiert. Die Übergabe der Leiterplatten 2 von der ersten Beschichtungsstation 4 in der ersten Gerätezeile A an die zweite Beschichtungsstation 6 in der zweiten Gerätezeile B erfolgt mit Hilfe der ersten Ablüft-und Trockenstation 5. In dieser werden die Leiterplatten gewendet und quer zur den Transportrichtungen X, Y in den Beschichtungsstationen 4, 6 aus der ersten Gerätezeile A in die zweite B umgesetzt werden. Auf diese Weise ist die Gesamtlänge der Beschichtungsanlage deutlich reduziert. Es sind auch keine zusätzlichen Umsetzmittel bzw. Querförderer für die Leiterplatten erforderlich.

Besonders vorteilhaft an der Beschichtungsanlage 1 gemäss Fig. 1 und 2 ist, dass die Leiterplatten 2 während ihres Transports von der ersten Beschichtungsstation 4 über die erste Ablüft- und Trockenstation 5 zur zweiten Beschichtungsstation 6 und schliesslich durch die zweite Ablüft- und Trockenstation 7 und während ihrer Übergabe an die verschiedenen Transportmittel in den einzelnen Stationen im wesentlichen ständig an den Längsrändern geführt oder gestützt werden.

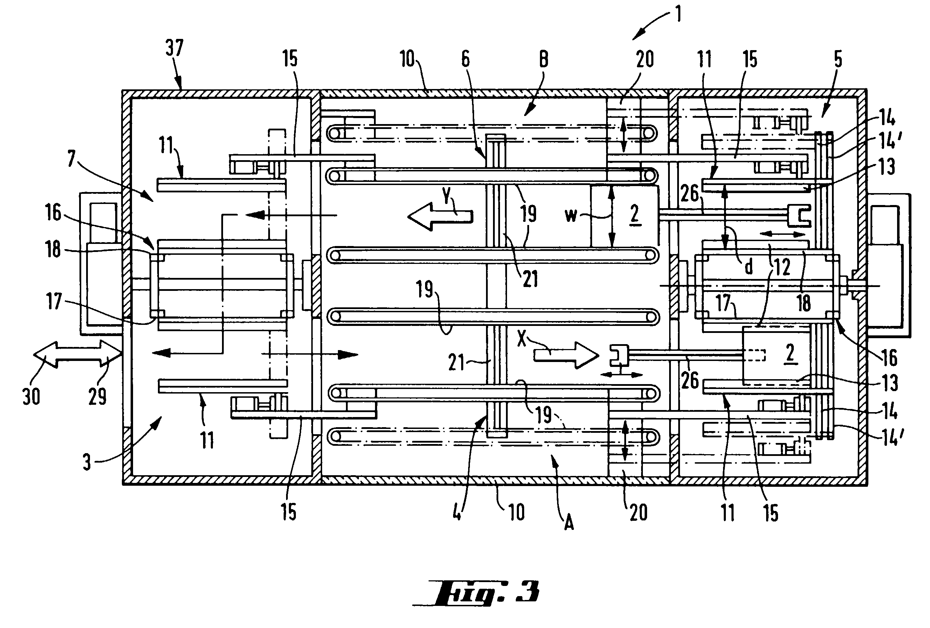

In Fig. 3 ist ein zweites Ausführungsbeispiel der erfindungsgemässen Beschichtungsanlage 1 zur beidseitigen Beschichtung von Leiterplatten dargestellt. Es entspricht weitgehend der in den Fig. 1 und 2 dargestellten Anlage. Der wesentlichste Unterschied besteht darin, dass die eingangseitige Vorwärmstation 3 und die ausgangseitige Ablüft- und Trockenstation 7 zu einem einzigen Umlauftrockner 37 zusammengefasst sind. Dabei ist der Umlauftrockner 37 derart angeordnet, dass seine Längserstreckung parallel zur Längserstreckung der ersten Ablüft- und Trockenstation 5 verläuft. Das heisst sie verläuft quer, vorzugsweise in einem 90° Winkel, zu den Transportrichtungen X, Y der Leiterplatten 2 in den Beschichtungsstationen 4, 6. Der Aufbau des Umlauftrockners 37 entspricht im wesentlichen dem Aufbau der ersten Ablüft- und Trockenstation 5. Insbesondere kann er auch Halterungen 11 aufweisen, die eine feste 12 und eine verschiebbare Halteschiene 13, umfassen, sodass die Breite d der Halterungen 11 auf die Breite w der einzuschiebenden Leiterplatten einstellbar ist.

Im Unterschied zur ersten Ablüft- und Trockenstation 5, die je eine Eingabeöffnung in Verlängerung der ersten Gerätezeile A und eine Ausgabeöffnung in Verlängerung der zweiten Gerätezeile B für die Leiterplatten 2 aufweist, welche auf derselben Längsseite der Station angeordnet sind, weist der Umlauftrockner 37 in Verlängerung der ersten Gerätezeile A, auf der den Beschichtungsstationen 4, 6 abgewandten Längsseite eine Eingabe- und eine Ausgabestation für die Leiterplatten 2 auf. In der Fig. 3 ist die Eingabestation durch den Pfeil 29 und ist die Ausgabestation durch den Pfeil 30 angedeutet. Die Eingabestation 29 ist oberhalb der Transportebene der Leiterplatten 2 in den Beschichtungsstationen 4, 6 angeordnet. Leiterplatten 2, die über die Eingabestation 29 in Halterungen 11 am abwärts führenden Trum 17 des Umlaufförderers 16 eingegeben werden, werden während des Transports nach unten vorgewärmt, und bei Erreichen des Niveaus der Transportebene der Leiterplatten in den Beschichtungsstationen in die gegenüberliegende erste Beschichtungsstation 4 ausgefahren. Die beidseitig beschichteten Leiterplatten 2, die von der zweiten Beschichtungsstation 6 kommend in Halterungen 11 am aufwärts führenden Trum 18 des Umlaufförderers 16 eingegeben werden, werden während ihres Transports durch den Umlauftrockner getrocknet, dabei gewendet und über die oberhalb der Eingabestation 29 angeordnete Ausgabestation 30 aus der Beschichtungsanlage 1 ausgefahren.

In Fig. 1 ist oberhalb der ersten Beschichtungsstation 4 ein Gehäuse 9 angedeutet, welches sich von der Vorwärmstation 3 bis zur ersten, quer zur Transportrichtung der Leiterplatten angeordneten Ablüft- und Trockenstation 5 erstreckt. Es versteht sich, dass sich das Gehäuse 9 auch nach hinten, in die Tiefe der Zeichnungsebene fortsetzt, sodass es oberhalb der beiden Beschichtungsstationen 4, 6 von der Vorwärmstation 3 bzw. der zweiten Ablüft- und Trockenstation 7 bis zur ersten Ablüft- und Trockenstation 5 erstreckt. Das Gehäuse 9 ist dabei vorzugsweise derart bemessen, dass es nicht über die Breite und die Höhe der ersten Ablüft- und Trockenstation 5 hinausragt. Innerhalb des Gehäuses 9 ist ein Luftaufbereitungsmodul untergebracht, welches die Umlauftrockner der Vorwärmstation 3, sowie der ersten und der zweiten Ablüft- und Trockenstation 4, 6 mit Heissluft der gewünschten Temperatur versorgt, und die abgesaugte Abluft aufnimmt und gegebenenfalls aufbereitet. Ein derartiges Luftaufbereitungsmodul ist beispielsweise in der europäischen Patentanmeldung EP-A-0 586 772 beschrieben.

In den Fig. 1 bis 3 sind auch noch Schottwände 10 dargestellt, welche die Beschichtungsstationen 4, 6 im wesentlichen gegenüber der Umgebung abschotten. Vorzugsweise sind diese Schottwände 10 Plexiglaswände, die sich zwischen der kombinierten Vorwärm- und Ablüft- und Trockenstationen 37 und der ersten Ablüft und Trockenstation 5 bzw. zwischen der Vorwärmstation 3 und der zweiten Ablüft- und Trockenstation 7 einerseits und der ersten Ablüft- und Trockenstation 5 andererseits erstrecken. Wie in Fig. 1 dargestellt, reichen die Schottwände 10 zu beiden Seiten der Beschichtungsstationen 4, 6 von der Unterkante des Gehäuses 9 für das Luftaufbereitungsmodul bis etwa zum Boden. Für den Fall, dass der Raum oberhalb der Beschichtungsstationen 4, 6 nicht für die Unterbringung des Gehäuses für das Luftaufbereitungsmodul genützt wird und frei ist, sind die beiden Schottwände 10 durch eine Abdeckplatte verbunden, sodass sich die Beschichtungsstationen 4, 6 innerhalb einer Art Tunnel befinden, der sich über die gesamte Länge der Beschichtungsstationen erstreckt und einerseits von der Vorwärmstation 3 und der zweiten Ablüft- und Trockenstation 7 bzw. von dem kombinierten Umlauftrockner 37 und andererseits von der ersten Ablüft- und Trockenstation 5 begrenzt wird. Auf diese Weise kann das erforderliche Reinraumvolumen auf das Volumen innerhalb des Tunnels beschränkt werden; es ist nicht mehr erforderlich, das Luftvolumen des gesamten Raums, in dem die Beschichtungsanlage 1 untergebracht ist, auf die gewünschte Reinraumqualität zu bringen.

Die Beschichtungsstationen 4, 6 können jede einen eigenen Giesstisch mit allen erforderlichen Bestandteilen, wie beispielsweise Pumpen, Reservoir für den vorzugsweise UV-härtbaren Kunststoff, Lack oder dergleichen, Giesskopf mit Trennmessern etc., aufweisen. Vorzugsweise besitzen sie einen gemeinsamen Giesstisch 21 mit unabhängig voneinander antreibbaren und breitenverstellbaren seitlichen Führungsmitteln 19 für die Längsränder der zu beschichtenden Leiterplatten 2. Der Giesstisch ist dabei derart ausgebildet, dass er zwei frei fallende Giessvorhänge erzeugt, die nebeneinander angeordnet sind und jeweils etwa quer zu der Transportrichtung X, Y der Leiterplatten 2 in der jeweiligen Beschichtungsstation 4, 6 verlaufen. Die Giessvorhänge werden von einen einzigen gemeinsamen Reservoir gespeist, das oberhalb des Giesstisches angeordnet ist. Auf diese Weise ist nur mehr eine einzige Pumpe samt Viskositäts- und Temperaturregelung für den lichtempfindlichen Kunststoff, Lack oder dergleichen erforderlich.

Es versteht sich, dass die erfindungsgemässe Beschichtungsanlage 1 nicht allein auf die beschriebenen Ausführungsbeispiele beschränkt ist. Weitere nicht ausdrücklich dargestellte Varianten sind im Kern der Erfindung enthalten. Die Erfindung ist am Beispiel zweier Beschichtungsanlagen für Leiterplatten erläutert worden. Dies ist jedoch nicht einschränkend zu verstehen. Die erfindungsgemässe Beschichtungsanlage kann ganz allgemein zur beidseitigen Beschichtung von plattenförmigem Stückgut mit einem gewünschten Beschichtungsmaterial eingesetzt werden. Auch ist die Beschichtung nicht allein auf die Nass-Beschichtung mit flüssigen Beschichtungsmaterialien eingeschränkt.

Durch die Erfindung werden ein Verfahren und eine Vorrichtung zur beidseitigen Beschichtung von plattenförmigem Stückgut, insbesondere von Leiterplatten geschaffen, welche ohne zusätzliche Querförderer auskommen. Die Vorrichtung ist kompakt und weist eine relativ kurze Baulänge auf. Auch ist die Bauhöhe der Gesamtanlage relativ gering und im wesentlichen nur durch die Bauhöhe der vertikalen Durchlauftrockner bestimmt.

## Patentansprüche

1. Verfahren zur beidseitigen Beschichtung von plattenförmigem Stückgut, insbesondere von Leiterplatten, bei dem das Stückgut (2) durch mehrere aufeinanderfolgende Bearbeitungsstationen einer Beschichtungsanlage (1) transportiert wird und in einer ersten Beschichtungsstation (4) zunächst eine erste Seite des Stückguts (2) mit vorzugsweise UV-härtbarem Kunststoff oder Lack nass beschichtet wird, nach dem Beschichten der ersten Seite das Stückgut (2) in einer ersten Ablüft- und Trockenstation (5) jeweils abgelüftet und zumindest teilweise getrocknet wird, das Stückgut (2) gewendet und in einer zweiten Beschichtungsstation (6) die zweite Seite mit vorzugsweise UV-härtbarem Kunststoff oder Lack nass beschichtet wird und das derart beidseitig beschichtete Stückgut in einer zweiten Ablüft- und Trockenstation (7) abgelüftet und getrocknet wird und schliesslich zur weiteren Bearbeitung aus der Beschichtungsanlage (1) an weitere Bearbeitungsvorrichtungen übergeben wird, dadurch gekennzeichnet, dass das Stückgut (2) in entgegengesetzte Richtungen (X bzw. Y) durch die beiden Beschichtungsstationen (4 bzw. 6) transportiert wird, welche in zwei parallel zueinander verlaufenden Gerätezeilen (A bzw. B) nebeneinander angeordnet sind, und dass das Stückgut (2) in der ersten Ablüft- und Trockenstation (5) gewendet und aus der ersten Gerätezeile (A) in die zweite (B) umgesetzt wird.

2. Verfahren nach Anspruch 1, dadurch gekennzeichnet, dass die Leiterplatten (2) eingangs der Beschichtungsanlage (1) vor dem Transport durch die erste Beschichtungsstation (4) in einer Vorwärmstation (3) vorgewärmt werden.

3. Verfahren nach Anspruch 2, dadurch gekennzeichnet, dass die Vorwärmstation (3) und die zweite Ablüft- und Trockenstation (7) durch einen einzigen Umlauftrockner (37) gebildet werden, und dass die Leiterplatten (2) nach der beidseitigen Beschichtung während des abschliessenden Ablüft- und Trockenvorgangs im Umlauftrockner (37) aus der zweiten Gerätezeile (B) wieder in die erste Gerätezeile (A) umgesetzt werden.

4. Verfahren nach Anspruch 3, dadurch gekennzeichnet, dass die Leiterplatten (2) eingangs des Umlauftrockners (37) in Halterungen (11) eingegeben werden, die an einem abwärtsbewegten Trum (17) eines Umlaufförderers (16), vorzugsweise eines Kettenförderers, der im Umlauftrockner (37) angeordnet ist, befestigt sind, wobei die Eingabeebene (29) oberhalb der Transportebene (T) der Leiterplatten (2) in der ersten Beschichtungsstation (4) verläuft, und dass die Leiterplatten (2) nach dem abschliessenden Ablüften- und Trocknen aus den abwärtsbewegten Halterungen (11) des Umlauftrockners (37) ausgefahren werden, wobei die Ausgabeebene (30) oberhalb der Eingabeebene (29) verläuft.

5. Verfahren nach einem der vorangehenden Ansprüche, dadurch gekennzeichnet, dass die Leiterplatten (2) während ihres Transportes durch die einzelnen Bearbeitungsstationen der Beschichtungsanlage (1) und während ihrer Übergabe an die verschiedenen Transportmittel der einzelnen Bearbeitungsstationen im wesentlichen ständig an den Längsrändern geführt oder gestützt werden.

6. Vorrichtung zur beidseitigen Beschichtung von plattenförmigem Stückgut (2), insbesondere von Leiterplatten, mit einer Reihe von Bearbeitungsstationen, die nacheinander von dem Stückgut (2) durchlaufen werden, welche Bearbeitungsstationen in der Reihenfolge ihrer Anordnung eine erste Beschichtungsstation (4) , eine erste Ablüft - und Trockenstation (5), eine zweite Beschichtungsstation (6) und eine zweite Ablüft- und Trockenstation (7) umfassen, dadurch gekennzeichnet, dass die erste und die zweite Beschichtungsstation (4, 6) in zwei parallel zueinander verlaufenden Gerätezeilen (A, B) mit entgegengesetzten Transportrichtungen (X, Y) nebeneinander angeordnet sind, dass die erste Ablüft- und Trockenstation (5) derart zwischen der ersten und der zweiten Beschichtungsstation (4, 6) angeordnet ist, dass ihre Längserstreckung quer zu den Transportrichtungen (X, Y) des Stückguts (2) in den Beschichtungsstationen (4, 6) verläuft und Halterungen (11) für das Stückgut (2), die am aufwärts führenden Trum (17) eines in der ersten Ablüft- und Trockenstation (5) vorgesehenen Umlaufförderers (16), vorzugsweise eines Kettenförderers, der das Stückgut wendet befestigt sind, sich quer und benachbart zur ersten Gerätezeile (A) erstrecken während Halterungen (11), die am abwärts führenden Trum (18) des Umlaufförderers (16) befestigt sind, sich quer und benachbart zur zweiten Gerätezeile (B) erstrecken.

7. Vorrichtung nach Anspruch 6, dadurch gekennzeichnet, dass eingangs der Beschichtungsanlage (1) vor der ersten Beschichtungsstation (4) eine Vorwärmstation (3) für die Leiterplatten (2) angeordnet ist.

8. Vorrichtung nach Anspruch 7, dadurch gekennzeichnet, dass die Vorwärmstation (3) und die zweite Ablüft- und Trockenstation (7) durch einen Umlauftrockner (37) gebildet sind, dessen Längserstreckung parallel zur Längserstreckung der ersten Ablüft- und Trockenstation (5) verläuft, und der eine Eingabe- und eine Ausgabestation (29, 30) für die Leiterplatten (2) aufweist, die etwa mit der ersten Gerätezeile (A) fluchtend im Bereich des abwärtsführenden Trums des (17) innerhalb des Umlauftrockners (37) angeordneten Umlaufförderers (16), vorzugsweise eines Kettenförderers, derart angeordnet sind, dass die Eingabeebene (29) oberhalb der Transportebene (T) der Leiterplatten (2) in der ersten Beschichtungsstation (4) und unterhalb der Ausgabeebene (30) verläuft

9. Vorrichtung nach einem der Ansprüche 6 - 8, dadurch gekennzeichnet, dass die Breite (d) der Halterungen (11) für die Leiterplatten (2) in den Ablüft- und Trockenstationen (5, 7; 37) auf die Breite (w) der Leiterplatten (2) einstellbar ist.

10. Vorrichtung nach Anspruch 9, dadurch gekennzeichnet, dass jede Halterung (11) zwei parallel angeordnete Halteschienen (12, 13) für die Längsränder der Leiterplatten (2) umfasst, dass eine der Halteschienen (12) fest mit dem Umlaufförderer (16) verbunden ist, während die andere Halteschiene (13) mit Hilfe von Verstellmitteln (15) entlang einer Führungsstange (14), die sich senkrecht zu der festen Halteschiene (12) erstreckt und fest mit ihr verbunden ist, vorzugsweise gebremst, derart parallelverschiebbar ist, dass der Abstand (d) zwischen den Halteschienen (12, 13) auf die Breite (w) der einzufahrenden Leiterplatte (2) einstellbar ist.

11. Vorrichtung nach Anspruch 10, dadurch gekennzeichnet, dass die Längsränder der Leiterplatten (2) in jeder Beschichtungsstation (4, 6) von seitlichen Führungsmitteln (19) gehalten werden, die mit vorzugsweise elektro-pneumatischen Verstellmitteln (20) jeweils automatisch auf die Breite (w) einer zu beschichtenden Leiterplatte (2) einstellbar sind, und dass die Verstellmittel (15) für die Breitenverstellung der Tragelemente (11) der Abluft- und Trockenstationen (5, 7; 37) und die Verstellmittel (20) für die Breitenverstellung der seitlichen Führungsmittel (19) für die Längsränder der Leiterplatten (2) in den Beschichtungsstationen (4, 6) miteinander gekoppelt sind.

12. Vorrichtung nach einem der Ansprüche 6 - 11, dadurch gekennzeichnet, dass die erste Ablüft- und Trockenstation (5) ein Luftaufbereitungsmodul aufweist, welches in einem Gehäuse (9) angeordnet ist, das eingabe- bzw. ausgabeseitig an den Ablüfttrockners (5) anschliesst und sich über den freien Raum oberhalb der Beschichtungsstationen (4, 6) erstreckt.

13. Vorrichtung nach Anspruch 12, dadurch gekennzeichnet, dass die erste Ablüft- und Trockenstation (5) und die zweite Ablüft- und Trockenstation (7) und gegebenenfalls die Vortrockenstation (3) ein gemeinsames Luftaufbereitungsmodul aufweisen, welches in einem Gehäuse (9) angeordnet ist, das an die Trockenstationenen (5, 3, 7; 37) anschliesst und sich zwischen den Stationen über den freien Raum oberhalb der Beschichtungsstationen (4, 6) erstreckt.

14. Vorrichtung nach einem der Ansprüche 6 - 13, dadurch gekennzeichnet, dass die Beschichtungsstationen (4, 6) durch bauliche Massnahmen, vorzugsweise durch Plexiglaswände (10), die sich zwischen den Ablüft- und Trockenstationen (5, 3, 7; 37) erstrecken und gegebenenfalls von der Unterkante des Gehäuses (9) für das Luftaufbereitungsmodul bis zum Boden reichen, im wesentlichen von der Umgebungluft abgeschottet sind.

15. Vorrichtung nach einem der Ansprüche 11 - 14, dadurch gekennzeichnet, dass die beiden nebeneinander angeordneten Beschichtungsstationen (4, 6) einen gemeinsamen Giesstisch (21) mit unabhängig voneinander antreibbaren seitlichen Führungsmitteln (19) für die Längsränder der Leiterplatten (2) in der ersten Beschichtungsstation (4) und in der zweiten Beschichtungsstation (6) umfassen, und dass der Giesstisch (21) zwei frei fallende Giessvorhänge aus vorzugsweise UV-härtbarem Kunststoff, Lack oder dergleichen aufweist, die aus einem gemeinsamen oberhalb der Transportebene (T) der Leiterplatten (2) angeordneten Reservoir gespeist werden.

## Claims

1. A method of coating board-shaped piece material, especially printed circuit boards, on both sides, in which method the piece material (2) is transported through several consecutive processing stations of a coating installation (1) and, in a first coating station (4), first one side of the piece material (2) is wet-coated with preferably UV-hardenable plastics or lacquer, and, after that first side has been coated, the piece material (2) is subjected to vapour-removal and at least partially dried in a first vapour-removal and drying station (5), the piece material (2) is turned and, in a second coating station (6), the second side is wet-coated with preferably UV-hardenable plastics or lacquer, and the piece material so coated on both sides is subjected to vapour-removal and drying in a second vapour-removal and drying station (7) and is finally transferred from the coating installation (1) to other processing apparatuses for further processing, wherein the piece material (2) is transported in opposite directions (X and Y) through the two coating stations (4 and 6) which are arranged side by side in two parallel lines of apparatus (A and B), and, in the first vapour-removal and drying station (5), the piece material (2) is turned and is transferred from the first line of apparatus (A) to the second (B).

2. A method according to claim 1, wherein the printed circuit boards (2) are pre-heated in a preheating station (3) at the entrance to the coating installation (1) before they are transported through the first coating station (4).

3. A method according to claim 2, wherein the preheating station (3) and the second vapour-removal and drying station (7) are formed by a single circulating drier (37), and, after being coated on both sides, the printed circuit boards (2) are, during the final vapour-removal and drying operation in the circulating drier (37), transferred from the second apparatus line (B) back to the first apparatus line (A).

4. A method according to claim 3, wherein, at the entrance to the circulating drier (37), the printed circuit boards (2) are introduced into holding devices (11) which are secured to a descending section (17) of a circulating conveyor (16), preferably a chain conveyor, which is arranged in the circulating drier (37), the feed-in plane (29) extending above the transport plane (T) of the printed circuit boards (2) in the first coating station (4), and, after the final vapour-removal and drying, the printed circuit boards (2) are moved out of the descending holding devices (11) of the circulating drier (37), the delivery plane (30) extending above the feed-in plane (29).

5. A method according to any one of the preceding claims, wherein the printed circuit boards (2) are guided or supported substantially constantly at their longitudinal edges during their transport through the individual processing stations of the coating installation (1) and during their transfer to the various transport means of the individual processing stations.

6. An apparatus for coating board-shaped piece material (2), especially printed circuit boards, on both sides, having a series of processing stations through which the piece material (2) passes in succession, which processing stations comprise, in the sequence of their arrangement, a first coating station (4), a first vapour-removal and drying station (5), a second coating station (6) and a second vapour-removal and drying station (7), wherein the first and the second coating stations (4, 6) are arranged side by side in two parallel apparatus lines (A, B) having opposite directions of transport (X, Y), the first vapour-removal and drying station (5) is arranged between the first and the second coating stations (4, 6) in such a manner that its longitudinal extent is transverse to the transport directions (X, Y) of the piece material (2) in the coating stations (4, 6), and holding devices (11) for the piece material (2), which devices are secured to the ascending section (17) of a circulating conveyor (16), preferably a chain conveyor, provided in the first vapour-removal and drying station (5), which turns the piece material, extend across and adjacent to the first apparatus line (A) while holding devices (11) that are secured to the descending section (18) of the circulating conveyor (16) extend across and adjacent to the second apparatus line (B).

7. An apparatus according to claim 6, wherein a preheating station (3) for the printed circuit boards (2) is arranged at the entrance to the coating installation (1), upstream of the first coating station (4).

8. An apparatus according to claim 7, wherein the preheating station (3) and the second vapour-removal and drying station (7) are formed by a circulating drier (37), the longitudinal extent of which is parallel to the longitudinal extent of the first vapour-removal and drying station (5) and which has a feed-in and a delivery station (29, 30) for the printed circuit boards (2), which stations are so arranged approximately in line with the first apparatus line (A) in the region of the descending section (17) of the circulating conveyor (16), preferably a chain conveyor, arranged inside the circulating drier (37) that the feed-in plane (29) extends above the plane of transport (T) of the printed circuit boards (2) in the first coating station (4) and below the delivery plane (30).

9. An apparatus according to any one of claims 6 to 8, wherein the width (d) of the holding devices (11) for the printed circuit boards (2) in the vapour-removal and drying stations (5, 7; 37) is adjustable to the width (w) of the printed circuit boards (2).

10. An apparatus according to claim 9, wherein each holding device (11) comprises two parallel holding rails (12, 13) for the longitudinal edges of the printed circuit boards (2), one of the holding rails (12) is fixedly connected to the circulating conveyor (16) while the other holding rail (13) is, by means of adjusting means (15), so displaceable in a parallel, and preferably braked, manner along a guide rod (14), which extends perpendicularly to the fixed holding rail (12) and is fixedly connected thereto, that the distance (d) between the holding rails (12, 13) can be adjusted to the width (w) of the printed circuit board (2) to be introduced.

11. An apparatus according to claim 10, wherein the longitudinal edges of the printed circuit boards (2) are held in each coating station (4, 6) by lateral guide means (19) which can be adjusted automatically, by preferably electro-pneumatic adjusting means (20), to the width (w) of a printed circuit board (2) to be coated, and the adjusting means (15) for the width adjustment of the carrying elements (11) of the vapour-removal and drying stations (5, 7; 37) and the adjusting means (20) for the width adjustment of the lateral guide means (19) for the longitudinal edges of the printed circuit boards (2) in the coating stations (4, 6) are coupled to one another.

12. An apparatus according to any one of claims 6 to 11, wherein the first vapour-removal and drying station (5) has an air processing module arranged in a housing (9) which adjoins the feed-in and delivery side of the vapour-removal drier (5) and extends over the free space above the coating stations (4, 6).

13. An apparatus according to claim 12, wherein the first vapour-removal and drying station (5) and the second vapour-removal and drying station (7) and, if applicable, the predrying station (3) have a common air processing module arranged in a housing (9) which adjoins the drying stations (5, 3, 7; 37) and extends between the stations over the free space above the coating stations (4, 6).

14. An apparatus according to any one of claims 6 to 13, wherein the coating stations (4, 6) are substantially sealed off from the surrounding air by structural measures, preferably by Plexiglas walls (10), which extend between the vapour-removal and drying stations (5, 3, 7; 37) and, if applicable, from the lower edge of the housing (9) for the air processing module to the floor.

15. An apparatus according to any one of claims 11 to 14, wherein the two coating stations (4, 6) arranged side by side have a common pouring table (21) with lateral guide means (19) that can be driven independently of one another for the longitudinal edges of the printed circuit boards (2) in the first coating station (4) and in the second coating station (6), and the pouring table (21) has two free-falling pouring curtains of preferably UV-hardenable plastics, lacquer or the like which are supplied by a common reservoir arranged above the plane of transport (T) of the printed circuit boards (2).

## Revendications

1. Procédé pour le revêtement à deux faces d'articles individuels en forme de plaques, notamment des plaquettes à circuits imprimés, procédé dans lequel les articles individuels (2) sont transportés à travers plusieurs postes de traitement successifs d'une installation de revêtement (1) et, dans un premier poste de revêtement (4), une première face des articles individuels (2) est tout d'abord revêtue, à l'état humide, à l'aide d'une matière plastique ou d'un vernis préférentiellement durcissable sous l'action des UV ; après le revêtement de la première face, les articles individuels (2) sont respectivement ventilés et au moins partiellement séchés dans un premier poste (5) de ventilation et de séchage, les articles individuels (2) sont retournés et, dans un second poste de revêtement (6), la seconde face est revêtue à l'état humide à l'aide d'une matière plastique ou d'un vernis préférentiellement durcissable sous l'action des UV ; et les articles individuels ainsi revêtus sur deux faces sont ventilés et séchés dans un second poste (7) de ventilation et de séchage et sont, pour finir, transférés à d'autres dispositifs de traitement à partir de l'installation de revêtement (1), en vue du traitement ultérieur, caractérisé par le fait que les articles individuels (2) sont transportés, dans des directions opposées (X, respectivement Y), à travers les deux postes de revêtement (4, respectivement 6) qui sont agencés en juxtaposition dans deux alignements d'appareils (A, respectivement B) s'étendant parallèlement l'un à l'autre ; et par le fait que les articles individuels (2) sont retournés dans le premier poste (5) de ventilation et de séchage, puis sont transférés du premier alignement d'appareils (A) au second (B).

2. Procédé selon la revendication 1, caractérisé par le fait que les plaquettes (2) à circuits imprimés sont préchauffées dans un poste de préchauffage (3), à l'entrée de l'installation de revêtement (1), préalablement au transport à travers le premier poste de revêtement (4).

3. Procédé selon la revendication 2, caractérisé par le fait que le poste de préchauffage (3) et le second poste (7) de ventilation et de séchage sont formés par un unique sécheur (37) en boucle fermée ; et par le fait que les plaquettes (2) à circuits imprimés sont de nouveau transférées du second alignement d'appareils (B) au premier alignement d'appareils (A) à l'issue du revêtement sur deux faces, au cours du processus de ventilation et de séchage en phase d'achèvement dans le sécheur (37) en boucle fermée.

4. Procédé selon la revendication 3, caractérisé par le fait que les plaquettes (2) à circuits imprimés sont introduites, à l'entrée du sécheur (37) en boucle fermée, dans des supports (11) qui sont fixés à un brin descendant (17) d'un convoyeur (16) en boucle fermée, de préférence un convoyeur à chaines, disposé dans le sécheur (37) en boucle fermée, le plan d'amenée (29) s'étendant au-dessus du plan de transport (T) des plaquettes (2) à circuits imprimés dans le premier poste de revêtement (4) ; et par le fait que, après la ventilation et le séchage en phase d'achèvement, les plaquettes (2) à circuits imprimés sont extraites des supports (11), déplacés vers le bas, du sécheur (37) en boucle fermée, le plan d'évacuation (30) s'étendant au-dessus du plan d'amenée (29).

5. Procédé selon l'une des revendications précédentes, caractérisé par le fait que les plaquettes (2) à circuits imprimés sont, pour l'essentiel en permanence, guidées ou soutenues par les bords longitudinaux au cours de leur transport à travers les postes de traitement individuels de l'installation de revêtement (1) et au cours de leur transfert aux divers moyens de transport des postes de traitement individuels.

6. Dispositif pour le revêtement à deux faces d'articles individuels (2) en forme de plaques, notamment des plaquettes à circuits imprimés, comportant une rangée de postes de traitement successivement parcourus par les articles individuels (2), lesquels postes de traitement comprennent, dans l'ordre successif de leur agencement, un premier poste de revêtement (4), un premier poste (5) de ventilation et de séchage, un second poste de revêtement (6) et un second poste (7) de ventilation et de séchage, caractérisé par le fait que les premier et second postes de revêtement (4, 6) sont agencés en juxtaposition dans deux alignements d'appareils (A, B) à directions de transport opposées (X, Y), s'étendant parallèlement l'un à l'autre ; et par le fait que le premier poste (5) de ventilation et de séchage est interposé entre les premier et second postes de revêtement (4, 6) de façon telle que son étendue longitudinale soit orientée transversalement par rapport aux directions (X, Y) du transport des articles individuels (2) dans les postes de revêtement (4-, 6), et des supports (11) affectés aux articles individuels (2), qui sont fixés au brin ascendant (17) d'un convoyeur (16) en boucle fermée prévu dans le premier poste (5) de ventilation et de séchage, de préférence un convoyeur à chaînes qui retourne les articles individuels, s'étendent transversalement par rapport au premier alignement d'appareils (A) au voisinage de ce dernier, tandis que des supports (11), fixés au brin descendant (18) du convoyeur (16) en boucle fermée, s'étendent transversalement par rapport au second alignement d'appareils (B) au voisinage de ce dernier.

7. Dispositif selon la revendication 6, caractérisé par le fait qu'un poste (3) de préchauffage des plaquettes (2) à circuits imprimés est disposé à l'entrée de l'installation de revêtement (1), avant le premier poste de revêtement (4).

8. Dispositif selon la revendication 7, caractérisé par le fait que le poste de préchauffage (3) et le second poste (7) de ventilation et de séchage sont formés par un sécheur (37) en boucle fermée, dont l'étendue longitudinale est orientée parallèlement à l'étendue longitudinale du premier poste (5) de ventilation et de séchage, et qui présente un poste d'amenée (29) et un poste d'évacuation (30) des plaquettes (2) à circuits imprimés, lesquels postes, coïncidant sensiblement avec le premier alignement d'appareils (A), sont disposés dans la région du brin descendant (17) du convoyeur (16) en boucle fermée, de préférence un convoyeur à chaînes situé à l'intérieur du sécheur (37) en boucle fermée, de façon telle que le plan d'amenée (29) s'étende au-dessus du plan (T) de transport des plaquettes (2) à circuits imprimés dans le premier poste de revêtement (4), et au-dessous du plan d'évacuation (30).

9. Dispositif selon l'une des revendications 6-8, caractérisé par le fait que la largeur (d) des supports (11) affectés aux plaquettes (2) à circuits imprimés, dans les postes (5, 7 ; 37) de ventilation et de séchage, peut être réglée en fonction de la largeur (w) desdites plaquettes (2) à circuits imprimés.

10. Dispositif selon la revendication 9, caractérisé par le fait que chaque support (11) comprend deux glissières (12, 13), agencées parallèlement, pour la retenue des bords longitudinaux des plaquettes (2) à circuits imprimés ; et par le fait que l'une (12) des glissières de retenue est reliée rigidement au convoyeur (16) en boucle fermée, tandis que l'autre glissière de retenue (13) peut être animée de coulissements parallèles de préférence avec effet de freinage, à l'aide de moyens de déplacement (15), le long d'une barre de guidage (14) s'étendant perpendiculairement à la glissière fixe de retenue (12) à laquelle elle est reliée rigidement, de telle sorte que la distance (d) entre les glissières de retenue (12, 13) puisse être réglée en fonction de la largeur (w) de la plaquette (2) à circuits imprimés devant être insérée.

11. Dispositif selon la revendication 10, caractérisé par le fait que les bords longitudinaux des plaquettes (2) à circuits imprimés sont retenus, dans chaque poste de revêtement (4, 6), par des moyens de guidage latéral (19) pouvant être respectivement réglés en mode automatique, par des moyens de déplacement (20) de préférence électropneumatiques, en fonction de la largeur (w) d'une plaquette (2) à circuits imprimés devant être revêtue ; et par le fait que les moyens de déplacement (15) assurant le réglage en largeur des éléments de support (11) des postes (5, 7 ; 37) de ventilation et de séchage, et les moyens de déplacement (20) assurant le réglage en largeur des moyens (19) de guidage latéral des bords longitudinaux des plaquettes (2) à circuits imprimés, sont couplés les uns aux autres dans les postes de revêtement (4, 6).

12. Dispositif selon l'une des revendications 6-11, caractérisé par le fait que le premier poste (5) de ventilation et de séchage présente un module de préparation d'air, logé dans un carter (9) qui est respectivement attenant, côté amenée et côté évacuation, au sécheur à ventilation (5), et s'étend sur l'espace libre au-dessus des postes de revêtement (4, 6).

13. Dispositif selon la revendication 12, caractérisé par le fait que le premier poste (5) de ventilation et de séchage et le second poste (7) de ventilation et de séchage, et éventuellement le poste (3) de séchage préalable, présentent un module commun de préparation d'air, logé dans un carter (9) qui est attenant aux postes de séchage (5, 3, 7 ; 37) et s'étend, entre les postes, sur l'espace libre au-dessus des postes de revêtement (4, 6).

14. Dispositif selon l'une des revendications 6-13, caractérisé par le fait que les postes de revêtement (4, 6) sont, pour l'essentiel, isolés par rapport à l'air environnant grâce à des mesures structurelles, de préférence grâce à des parois (10) en "Plexiglas" qui s'étendent entre les postes (5, 3, 7 ; 37) de ventilation et de séchage, et se prolongent éventuellement jusqu'au sol à partir du bord supérieur du carter (9) affecté au module de préparation d'air.

15. Dispositif selon l'une des revendications 11-14, caractérisé par le fait que les deux postes de revêtement (4, 6), agencés en juxtaposition, comprennent un plateau commun de déversement (21) muni de moyens (19), entraînables indépendamment les uns des autres, pour le guidage latéral des bords longitudinaux des plaquettes (2) à circuits imprimés dans le premier poste de revêtement (4) et dans le second poste de revêtement (6) ; et par le fait que le plateau de déversement (21) présente deux voiles de déversement à chute libre qui sont constitués d'une matière plastique, d'un vernis ou d'une substance analogue préférentiellement durcissable sous l'action des UV, et sont alimentés à partir d'un réservoir commun placé au-dessus du plan (T) de transport des plaquettes (2) à circuits imprimés.
